(19) Europäisches Patentamt
European Patent Office
Office européen des brevets

(11) **EP 2 887 092 A1**

(12) **EUROPEAN PATENT APPLICATION**

(43) Date of publication:
**24.06.2015 Bulletin 2015/26**

(51) Int Cl.:
*G01S 7/41* (2006.01)　　*G06F 17/50* (2006.01)

(21) Application number: **13250119.8**

(22) Date of filing: **18.12.2013**

| | |
|---|---|
| (84) Designated Contracting States:<br>**AL AT BE BG CH CY CZ DE DK EE ES FI FR GB<br>GR HR HU IE IS IT LI LT LU LV MC MK MT NL NO<br>PL PT RO RS SE SI SK SM TR**<br>Designated Extension States:<br>**BA ME**<br><br>(71) Applicant: **BAE SYSTEMS plc<br>London SW1Y 5AD (GB)** | (72) Inventor: **The designation of the inventor has not<br>yet been filed**<br><br>(74) Representative: **BAE SYSTEMS plc<br>Group IP Department<br>P.O. Box 87<br>Warwick House<br>Farnborough Aerospace Centre<br>Farnborough<br>Hampshire GU14 6YU (GB)** |

(54) **Computing radar cross section**

(57)　　A computer implemented method of computing radar cross-section (RCS) of an object having a fully or partially open cavity is disclosed. The method comprises receiving data representing at least part of the object including the cavity as a mesh comprising a plurality of triangular elements and performing a ray tracing operation on the data to find rays paths in the cavity and exit rays. The method further comprises determining field amplitudes of the exit rays by calculating ray tube divergence factors and planar reflection coefficients, thereby producing a geometrical optics field, which is subsequently used to compute a backscattered field. The calculation of the ray tube divergence factors involve curvature information relating to said mesh which is computed by calculating a Weingarten curvature matrix over each said triangular element. The backscattered field is subsequently used to compute the RCS of at least part of the object represented by the data.

Figure 2

**Description**

The present invention relates to computing radar cross-section, and particularly, but not exclusively to computing radar cross-section of an object having a fully or partially-open cavity.

Radar cross-section (RCS) gives an indication of how detectable an object, such as a vehicle, is by radar. The RCS of a radar target is an effective area that intercepts the transmitted radar power and then scatters that power isotropically back to the radar receiver. It can be used in military and civilian applications, including target characterisation.

The computation of RCS is complex and so calculating it quickly and accurately is technically challenging. Certain types of objects or object features can be specifically designed to have low RCS/radar observability and so being able to quickly and accurately compute RCS can be beneficial during the design process. Particularly problematic in terms of RCS minimisation are objects/features that have open cavities, such as ducts or jet pipes in an aircraft. Such cavities can cause electromagnetic scattering during radar detection, thereby increasing the RCS of the entire aircraft and acting as a key target identification feature.

A number of techniques, such as geometric theory of diffraction, physical optics, differential-equation methods and finite element methods, have been investigated by researchers for producing effective and efficient radar signatures for both simple and complex cavity geometries. Some of these known methods of RCS calculation involve ray-tracing operations, which are particularly intensive computationally. It would therefore be desirable to provide a method of quickly and accurately calculating the RCS of an object having a partially open cavity.

Embodiments of the present invention are intended to address at least some of the abovementioned problems.

According to a first aspect of the present invention there is provided a computer implemented method of computing radar cross-section (RCS) of an object having a fully or partially-open cavity, the method including or comprising:

receiving data representing at least part of the object including the cavity as a mesh comprising a plurality of triangular elements;

performing a ray tracing operation on the data to find ray paths in the cavity and exit rays;

determining field amplitudes of the exit rays by calculating ray tube divergence factors and planar reflection coefficients, thereby producing a geometrical optics field;

using the geometrical optics field to compute a backscattered field, and

using the backscattered field to compute the RCS of at least part of the object represented by the data,

wherein the calculation of the ray tube divergence factor involves curvature information relating to said mesh that is computed by calculating a Weingarten curvature matrix over each said triangular element.

Preferably, the method further comprises outputting the computed RCS to an output device, such as a display device or a processor for subsequent processing.

In an embodiment, the ray tracing operation comprises first mathematically defining the cavity and subsequently applying Snell's Law to determine the direction of the rays at each reflection within the cavity, until the rays subsequently exit the cavity.

The planar reflection coefficients used to track the amplitude of the rays at each reflection include at least one of the electrical permittivity, magnetic permeability of a wall of the cavity and/or one or more coatings applied thereto.

In accordance with a second aspect of the present invention there is provided a system for computing radar cross-section (RCS) of an object having a fully or partially-open cavity, the system comprising a processor for receiving data representing the cavity and rays incident upon the cavity, the processor being arranged to process the data according to a method according to the first aspect.

Whilst the invention has been described above, it extends to any inventive combination of features set out above or in the following description. Although illustrative embodiments of the invention are described in detail herein with reference to the accompanying drawings, it is to be understood that the invention is not limited to these precise embodiments.

Furthermore, it is contemplated that a particular feature described either individually or as part of an embodiment can be combined with other individually described features, or parts of other embodiments, even if the other features and embodiments make no mention of the particular feature. Thus, the invention extends to such specific combinations not already described.

The invention may be performed in various ways, and, by way of example only, embodiments thereof will now be described, reference being made to the accompanying drawings in which:

Figure 1 is a schematic illustration of a system for computing radar cross-section according to an embodiment of the present invention;

Figure 2 is schematic illustration of a plurality of rays scattering from an aircraft duct;

Figure 3 is a flowchart sequencing the steps associated with a method of computing radar cross-section, according to an embodiment of the present invention; and,

Figure 4 is a schematic illustration of the vectors used to calculate the curvature matrix of an element of the mesh.

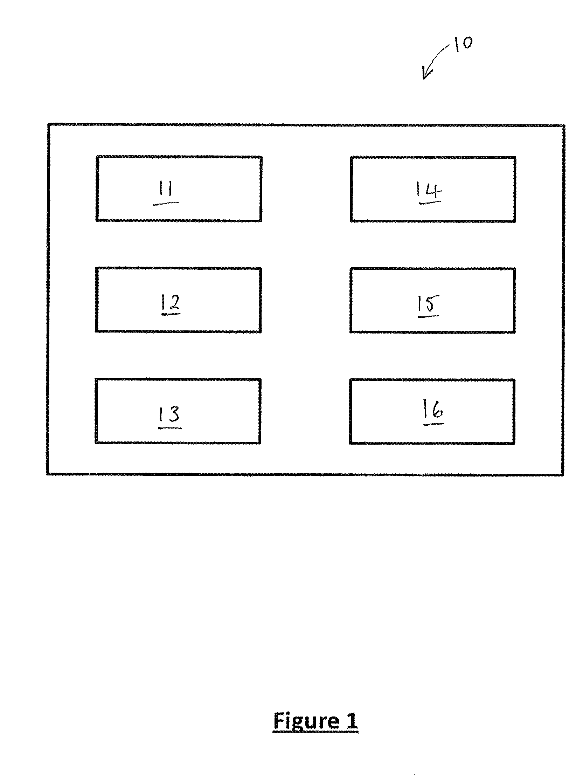

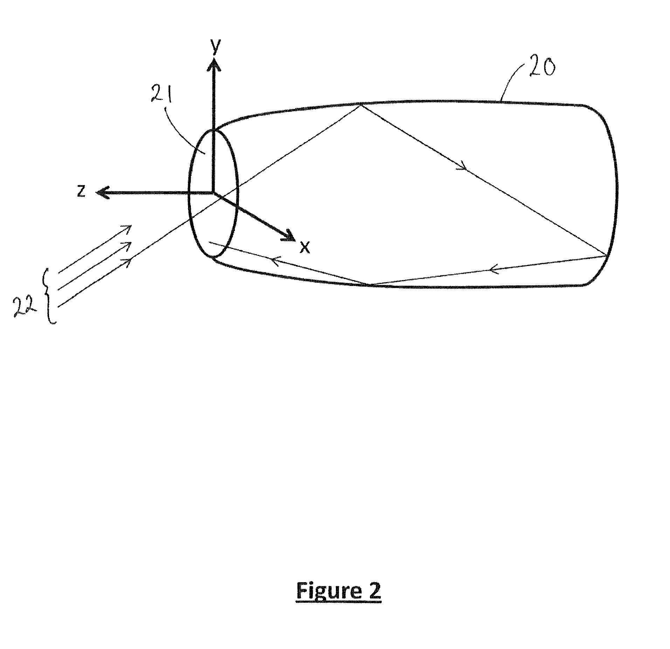

Referring to figure 1 of the drawings, there is illustrated a system according to an embodiment of the present invention for computing a radar cross-section (RCS) of an object having a fully or partially open cavity 20, such as an aircraft having a duct for exhausting the gases from a jet engine, as illustrated schematically in figure 2 of the drawings. The system 10 may comprise at least one conventional computing device 11 or server, but it will be understood that the functions it performs and/or the data it uses could be distributed over a plurality of computing devices and/or storage devices, including a cloud computing arrangement.

The computing device 11 may further include other conventional features, such as a user interface 12, which need not be described herein in detail, which enables an operator (not shown) to input suitable commands and data for the computation of the RCS, a communications device 13 for enabling the computing device 11 to communicate between the various devices of the system 10 for example, via any suitable wired or wireless means/network and a processor 14 for processing the commands and inputted data. The system may further comprise an output device 15, such as a display screen for displaying the results of the computation or a further processor 16 for further processing of the results of the computation.

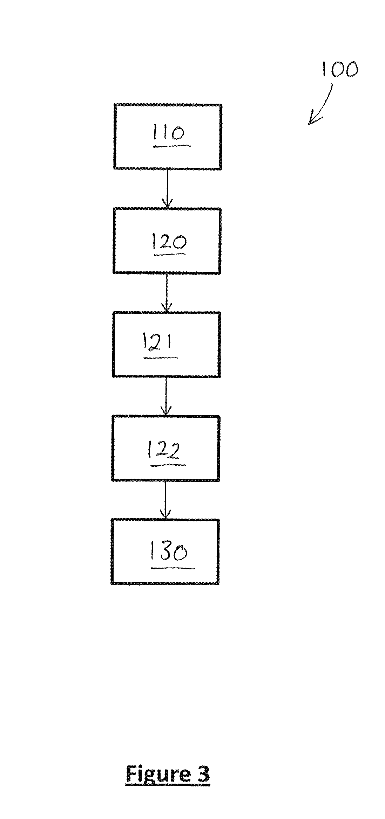

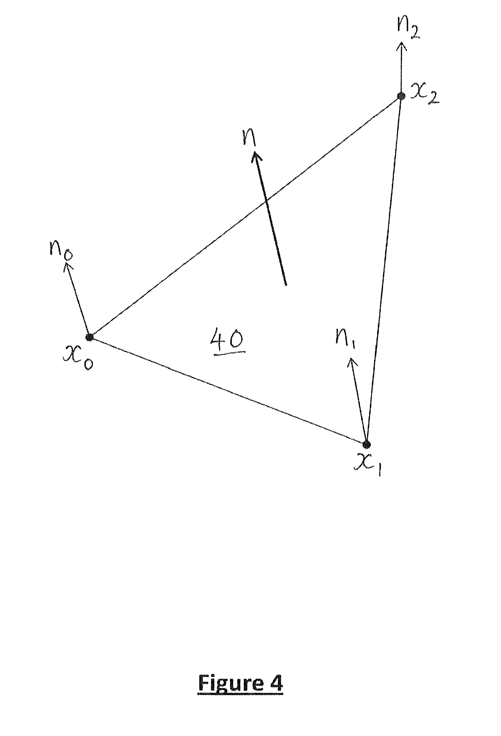

Referring to figure 3 of the drawings, there is illustrated a computer implemented method 100 of computing a radar cross-section of an object having a fully or partially open cavity, according to an embodiment of the present invention. The method comprises first mathematically representing at least a part of the object comprising the cavity 20 as a mesh (not shown) of triangular elements 40, at step 110, as illustrated in figure 4 of the drawings. A plurality of mathematically represented parallel rays 22, are then launched from a theoretical pixel array towards a geometric primitive representing the object comprising the cavity 20 or partially-open cavity at step 120. The rays are modelled as plane waves according to the relation:

$$\vec{E}^i = [-\hat{\phi}^i I + \hat{\theta}^i \vec{I}] e^{j\vec{k}^i \cdot \vec{r}} \qquad (1)$$

where $\boldsymbol{k}^i$ is the wavevector having Cartesian components which are represented as $\vec{k}^i = k_0(\hat{x} \sin \theta^i \cos \phi^i + \hat{y} \sin \theta^i \sin \phi^i + \hat{z} \cos \theta^i)$,

$I$ is the amplitude of perpendicular (or vertical) polarisation,
$\vec{I}$ is the amplitude of the parallel (or horizontal) polarisation, and
$\hat{\phi}$ and $\hat{\theta}$ are unit vectors of the spherical polar coordinate space.

Rays that hit a "front side" of the elements 40, namely the side of the elements facing the interior of the cavity, may be recursively re-launched, namely reflected, whereas those that hit the "back side" of the elements 40 are terminated. For scattering from an open object such as a hollow duct, such as the cavity 20 the inner surfaces are rendered reflective by associating an inward-pointing unit vector with them. The outer surfaces are not active. Closed objects have the unit normal pointing outwards to indicate that they are active and reflect any ray incident thereon. Surfaces which have the unit normal vector facing away from the illuminated side do not contribute to the reflected field.

Each ray that is launched from the pixel array comprises a central ray and four axial rays, forming a "ray tube". The area of each ray tube is determinable from the four axial rays by computing their points of intersection with the surface on which they impinge. The rays which reflect out from the cavity 20 through the opening 21 or partial opening thus contribute to the backscattered field, and are computed by applying Huygen's principle to the tangential aperture fields, by computing a surface integral over each ray tube area, at step 130.

Based on geometrical optics, the paths of each individual ray within the cavity are determinable using Snell's law and the field amplitudes associated with each ray are calculated from the geometrical divergence factor, the polarisation and the material composition (e.g. dielectric or magnetic material) of the cavity 20 or coating (not shown) applied to the interior of the cavity 20, at step 121, using the relation:

$$\vec{E}(x_{i+1}^-, y_{i+1}^-, z_{i+1}^-) = (DF)_i \cdot (\bar{\bar{\Gamma}})_i \cdot \vec{E}(x_i^-, y_i^-, z_i^-)$$

$$\cdot e^{-j(phase)} \qquad (2)$$

where, $(\bar{\bar{\Gamma}})_i$ is the reflection coefficient matrix, which relates the fraction of incident wave energy that is reflected at the $i$th reflection,

$(DF)_i$ is the divergence factor matrix which governs the spreading of the differential ray tube from just after the $i$th reflection to just before the $(i+1)$th reflection and,

$\vec{E}(x_i^-, y_i^-, z_i^-)$ is the incident field at $(x_i, y_i, z_i)$.

For computation of the geometrical divergence factor, knowledge of the curvature over each element is required and the curvature of a given element can be represented using a curvature tensor. The curvature tensor is calculated for each triangular element 40 as a smooth function on the element at step 122. Each triangle of the mesh will comprise a set of vertex normals (no, $n_1$, $n_2$), and applying linear interpolations of the vertices ($x_0$, $x_1$, $x_2$) of the element 40, the location of the element 40 within the mesh can be determined while a linear interpolation of the vertex normals gives the normal n for the respective element, as illustrated in figure 4 of the drawings. This approach is found to produce a smooth-looking representation of the mesh.

The curvature tensor T of a smooth surface is a symmetric 3x3 matrix. The tensor can be interpreted as describing how the unit normal changes in a small neighbourhood. For a surface $\mathbf{x}(u, v)$, and its partial derivatives $x_u$ and $x_v$, the unit normal vector n and its partial derivatives can be represented as,

$$\mathbf{n} = \frac{\mathbf{x}_u \times \mathbf{x}_v}{\|\mathbf{x}_u \times \mathbf{x}_v\|} \quad , \quad \mathbf{n}_u = \frac{d\mathbf{n}}{du} \quad , \quad \mathbf{n}_v = \frac{d\mathbf{n}}{dv}$$

The computation of T from $x_u$, $x_v$, $n_u$ and $n_v$ follows from the application of classical concepts of differential geometry and by defining the following coefficients

$$E = \mathbf{x}_u \mathbf{x}_u \quad , \quad F = \mathbf{x}_u \mathbf{x}_v \quad , \quad G = \mathbf{x}_v \mathbf{x}_v$$
$$L = -\mathbf{n}_u \mathbf{x}_u \quad , \quad M_1 = -\mathbf{n}_u \mathbf{x}_v$$
$$M_2 = -\mathbf{n}_v \mathbf{x}_u \quad , \quad N = -\mathbf{n}_v \mathbf{x}_v$$

the Weingarten curvature matrix W can be expressed as

$$\mathbf{W} = \begin{pmatrix} \dfrac{LG - M_1 F}{EG - F^2} & \dfrac{M_2 G - N F}{EG - F^2} \\ \\ \dfrac{M_1 E - L F}{EG - F^2} & \dfrac{N E - M_2 F}{EG - F^2} \end{pmatrix}$$

and it can be shown for a smooth surface that $M_1 = M_2$

The eigenvalues $\kappa_1$, $\kappa_2$ and corresponding eigenvectors $w_1 = \begin{pmatrix} w_{11} \\ w_{12} \end{pmatrix}$ and $w_2 = \begin{pmatrix} w_{21} \\ w_{22} \end{pmatrix}$ define the Gaussian curvature $K$, the Mean curvature H and principle curvature directions $k_1$ and $k_2$,

$$K = \kappa_1 \kappa_2 \quad , \quad H = \frac{1}{2}(\kappa_1 + \kappa_2)$$

$$k_1 = w_{11} x_u + w_{12} x_v \quad , \quad k_2 = w_{21} x_u + w_{22} x_v$$

The curvature tensor T can then be expressed as

$$T = PDP^{-1}$$

where $P = (k_1, k_2, n)$ and

$$D = \begin{pmatrix} \kappa_1 & 0 & 0 \\ 0 & \kappa_2 & 0 \\ 0 & 0 & 0 \end{pmatrix}$$

In an alternative embodiment of a method of computing the RCS of an object (which is not illustrated), a set of parallel rays is launched from the incident direction toward the target object such as a cavity. In this so-called "shooting and bouncing ray" (SBR) method, each ray is traced as it bounces from one part of the target to another, until it exits the target. The field on the ray is calculated by the theory of geometrical optics, including the effects of ray tube divergence, polarization and material reflection coefficients. At the last reflection point on the target, a physical optics type integration of the induced surface currents is performed to calculate the far field contribution from this ray tube. Contributions from all rays are summed up at a far-field observation point to give rise to the final scattered field, namely the RCS.

The skilled person will appreciate that the steps shown are exemplary only and that in alternative embodiments, some of them may be omitted and/or re-ordered and in some cases at least one additional step can be included. It will also be appreciated that the process can be implemented using any suitable programming language and data structures.

## Claims

1. A computer implemented method of computing radar cross-section of an object having a fully or partially-open cavity, the method including or comprising:

   receiving data representing at least part of the object including the cavity as a mesh comprising a plurality of triangular elements;
   performing a ray tracing operation on the data to find ray paths in the cavity and exit rays;
   determining field amplitudes of the exit rays by calculating ray tube divergence factors and planar reflection coefficients, thereby producing a geometrical optics field;
   using the geometrical optics field to compute a backscattered field, and
   using the backscattered field to compute the radar cross-section of at least part of the object represented by the data and outputting the radar cross-section to an output device,
   wherein the calculation of the ray tube divergence factor involves curvature information relating to said mesh that is computed by calculating a Weingarten curvature matrix over each said triangular element.

2. A method according to claim 1, further comprising outputting the computed radar cross-section to an output device.

3. A method according to claim 1 or 2, wherein the ray tracing operation comprises first mathematically defining the cavity.

4. A method according to any preceding claim, further comprising applying Snell's Law to determine the direction of the rays at each reflection within the cavity, until the rays subsequently exit the cavity.

5. A system for computing radar cross-section of an object having a fully or partially-open cavity, the system comprising a processor for receiving data representing the cavity and rays incident upon the cavity, the processor being arranged to process the data according to the method of any preceding claim.

10

11

14

12

15

13

16

**Figure 1**

**Figure 2**

100

```
┌─────────────┐
│     110     │
└─────────────┘
       │
       ▼
┌─────────────┐
│     120     │
└─────────────┘
       │
       ▼
┌─────────────┐
│     121     │
└─────────────┘
       │
       ▼
┌─────────────┐
│     122     │
└─────────────┘
       │
       ▼
┌─────────────┐
│     130     │
└─────────────┘
```

**Figure 3**

**Figure 4**

Europäisches
Patentamt

European
Patent Office

Office européen
des brevets

# EUROPEAN SEARCH REPORT

Application Number

EP 13 25 0119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WEI GAO ET AL: "Impact of the divergence factor on accurate RCS calculation using shooting and bouncing rays", MICROWAVE, ANTENNA, PROPAGATION, AND EMC TECHNOLOGIES FOR WIRELESS COMMUNICATIONS (MAPE), 2011 IEEE 4TH INTERNATIONAL SYMPOSIUM ON, IEEE, 1 November 2011 (2011-11-01), pages 206-209, XP032118274, DOI: 10.1109/MAPE.2011.6156162 ISBN: 978-1-4244-8265-8 * the whole document * | 1-5 | INV. G01S7/41 G06F17/50 |
| Y | LING H ET AL: "Shooting and bouncing rays: calculating the RCS of an arbitrarily shaped cavity", IEEE TRANSACTIONS ON ANTENNAS AND PROPAGATION, IEEE SERVICE CENTER, PISCATAWAY, NJ, US, vol. 37, no. 2, 1 February 1989 (1989-02-01), pages 194-205, XP011480740, ISSN: 0018-926X, DOI: 10.1109/8.18706 * the whole document * | 1-5 | |
| | | | TECHNICAL FIELDS SEARCHED (IPC) |
| | | | G01S G06F |
| Y | CHEN-SHI DONG ET AL: "Curvatures estimation on triangular mesh", JOURNAL OF ZHEJIANG UNIVERSITY. SCIENCE, vol. 6, 1 August 2005 (2005-08-01), pages 128-136, XP055155039, DOI: 10.1007/BF02887228 * abstract * * sections "INTRODUCTION", "BACKGROUND", "ALGORITHM" * | 1-5 | |

-/--

The present search report has been drawn up for all claims

| Place of search | Date of completion of the search | Examiner |
|---|---|---|
| Munich | 26 November 2014 | Grübl, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

# EUROPEAN SEARCH REPORT

Application Number

EP 13 25 0119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ELIAS A RACHID: "Spectral domain: A numerical ray launching method for curved structures", ANTENNAS AND PROPAGATION (EUCAP), 2013 7TH EUROPEAN CONFERENCE ON, IEEE, 8 April 2013 (2013-04-08), pages 2352-2355, XP032430477, ISBN: 978-1-4673-2187-7 * the whole document * | 1-5 | |
| A | WEINMANN F ED - GLUBOKOV A ET AL: "Curvature interpolation of facetted surfaces for high-frequency RCS simulations", ANTENNAS AND PROPAGATION SOCIETY INTERNATIONAL SYMPOSIUM, 2008. AP-S 2008. IEEE, IEEE, PISCATAWAY, NJ, USA, 5 July 2008 (2008-07-05), pages 1-4, XP031824507, ISBN: 978-1-4244-2041-4 * the whole document * | 1-5 | |
| A | GAO WEI ET AL: "Non-uniform triangulation technique in the shooting and bouncing ray method", 2013 5TH IEEE INTERNATIONAL SYMPOSIUM ON MICROWAVE, ANTENNA, PROPAGATION AND EMC TECHNOLOGIES FOR WIRELESS COMMUNICATIONS, IEEE, 29 October 2013 (2013-10-29), pages 272-274, XP032536109, DOI: 10.1109/MAPE.2013.6689883 ISBN: 978-1-4673-6077-7 [retrieved on 2013-12-19] * the whole document * | 1-5 | TECHNICAL FIELDS SEARCHED (IPC) |

The present search report has been drawn up for all claims

| Place of search | Date of completion of the search | Examiner |
|---|---|---|
| Munich | 26 November 2014 | Grübl, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)